# EUROPEAN PATENT APPLICATION

(11) **EP 4 752 673 A1**
(43) Date of publication of application: **03.06.2026**
(21) Application number: 24307000.0
(22) Date of filing: 29.11.2024
(51) Int. Cl.: G05F 3/26, H03F 3/45

(54) **CURRENT MIRROR, GATE DRIVER AND METHOD FOR CONTROLLING AN OUTPUT CURRENT**

(71) Applicant: NXP USA, Inc., Austin TX 78735 (US)
(72) Inventor: ATTANASIO, Marco, 8101 Gratkorn (AT); RHINOW, Christoph, 8020 Graz (AT); RYABCHENKOV, Sergey Sergeevich, 31000 Toulouse (FR)
(74) Representative: Schmütz, Christian Klaus Johannes

(57) **Abstract**

A current mirror circuit (200) comprises: a first current source (206) for providing a first reference current (IB1); a first transistor (M1, 222) having a control terminal (226), a first current terminal (228) coupled to receive the first reference current (IB1), and a second current terminal (230) coupled to a reference potential (VEE); a second transistor (M2, 224) having a control terminal (232) coupled to the control terminal (226) of the first transistor (M1, 222), a first current terminal (234) coupled to an output node (GL, 208) of the current mirror circuit (200), and a second current terminal (236) coupled to the reference potential (VEE); and matching circuitry (300) having an input (302) coupled to the output node (GL, 208) of the current mirror circuit (200), and an output (304) coupled to the first current terminal (228) of the first transistor (M1, 222), the matching circuitry (300) being configured to provide, at the first current terminal (228) of the first transistor (M1, 222), a replica voltage corresponding to a voltage at the output node (GL, 208) of the current mirror circuit (200).

## Description

### FIELD

The present disclosure relates to a current mirror, a gate driver comprising a current mirror, and a method for controlling an output current.

### BACKGROUND

Implementing high-current and highly precise current mirrors generally requires large area occupation due to the presence of both large current mirror and cascodes, able to supply currents of 1.2A and above. In conventional current mirrors, a cascode may be used to provide the necessary robustness against VDS-modulation (drain-source voltage modulation), to provide a current of the order of several Amperes and to keep a good precision.

In high voltage (HV) applications, the cascode may be implemented with high voltage rating MOS transistors to protect the underlying low-voltage mirror, with VDS (drain-source voltage) that can be up to, e.g. 36V. However, in some cost-competitive technologies, such as junction-isolated technology, the maximum voltage difference between Source/Body and Substrate is limited to 300mV, meaning that HV devices with the necessary voltage rating for use as cascodes are not available. Thus it is not possible to implement an HV mirror with a cascode in such technologies, without use of a complex and costly technology based voltage extension. Implementing a conventional HV current mirror without cascode could lead to a significant decrease in performance.

### SUMMARY

Features of the invention are set out in the appended claims.

According to a first aspect of the disclosure, there is provided a current mirror circuit comprising: a first current source for providing a first reference current; a first transistor having a control terminal, a first current terminal coupled to receive the first reference current, and a second current terminal coupled to a reference potential; a second transistor having a control terminal coupled to the control terminal of the first transistor, a first current terminal coupled to an output node of the current mirror circuit, and a second current terminal coupled to the reference potential; and matching circuitry having an input coupled to the output node of the current mirror circuit, and an output coupled to the first current terminal of the first transistor, the matching circuitry being configured to provide, at the first current terminal of the first transistor, a replica voltage corresponding to a voltage at the output node of the current mirror circuit.

By replicating, at the first current terminal of the first transistor, the voltage at the first current terminal of the second transistor, the matching circuitry is able to mitigate VDS modulation effects in the current mirror circuit. As a result, the current mirror circuit of the present disclosure enables implementation of a non-cascoded current mirror, with performance comparable to that of a conventional cascoded low voltage (LV) current mirror. In addition, the current mirror of the present disclosure provides higher headroom than a cascoded current mirror circuit. Advantageously, the present disclosure can be applied to any conventional current mirror, regardless of its specific application.

In some embodiments, each of said first transistor and said second transistor is a high voltage transistor.

When applied to high voltage applications, a significant area saving may be achieved because the present invention enables implementation of a non-cascoded high voltage (HV) current mirror with performance comparable to that of a conventional cascoded low voltage (LV) current mirror.

In some embodiments, the replica voltage is a 1:1 copy of the voltage at the output node of the current mirror circuit.

In some embodiments, the control terminal of the first transistor is coupled to the first current terminal of the first transistor via a switch.

When the switch is closed, the current mirror circuit may operate as a simple current mirror. Accordingly, the switch may enable the current mirror to be selectively reconfigured between a simple current mirror mode and a precise current mirror mode.

In some embodiments, the first current terminal of the second transistor is directly connected to the output node of the current mirror circuit.

In some embodiments, the matching circuitry comprises: a third transistor having a control terminal, a first current terminal coupled to the control terminal of the third transistor, and a second current terminal; a fourth transistor having a control terminal coupled to the control terminal of the third transistor, a first current terminal, and a second current terminal; a second current source configured to control a second reference current between the first and second current terminals of the third transistor; and a third current source configured to control a third reference current between the first and second current terminals of the fourth transistor; wherein said second current terminal of said fourth transistor is coupled to said first current terminal of said first transistor.

The input of said matching circuitry may be coupled to the second current terminal of the third transistor. The output of said matching circuitry may be coupled to the second current terminal of the fourth transistor.

Advantageously, the matching circuitry provides open-loop matching of the voltage at the first current terminal of the second transistor to the voltage at the first current terminal of the first transistor, thereby enabling the current mirror circuit to perform real-time VDS-modulation compensation.

In some embodiments, the matching circuitry further comprises a fourth current source, configured to provide a fourth reference current to the second current terminal of the third transistor, wherein the fourth reference current is equal to the second reference current; and a fifth current source, configured to provide a fifth reference current to the second current terminal of the fourth transistor, wherein the fifth reference current is equal to the third reference current.

Inclusion of the fourth and fifth current sources in the matching circuitry may help to prevent the third and fourth transistors from draining current from the output node and the first current source respectively.

In some embodiments, the first reference current is equal to the second reference current.

In some embodiments, the first current terminal of the fourth transistor is coupled to the control terminal of the first transistor.

This feature may be helpful in providing a charging/discharging pathway for the control terminal of the first transistor, without adversely affecting the operation of the matching circuitry.

In some embodiments, the first transistor and the second transistor are NMOS transistors, and the third transistor and the fourth transistor are PMOS transistors.

In some embodiments, the first transistor and the second transistor are PMOS transistors, and the third transistor and the fourth transistor are NMOS transistors.

In embodiments in which the first, second, third and fourth transistors are MOS transistors, the control terminal, first current terminal and second current terminal of a respective one of said transistors may correspond respectively to the gate, drain and source of the respective transistor.

In some embodiments, the first transistor and the second transistor are NPN transistors, and the third transistor and the fourth transistor are PNP transistors.

In some embodiments, the first transistor and the second transistor are PNP transistors, and the third transistor and the fourth transistor are NPN transistors.

In embodiments in which the first, second, third and fourth transistors are bipolar junction transistors, the control terminal, first current terminal and second current terminal of a respective one of said transistors may correspond respectively to the base, collector and emitter of the respective transistor.

According to a second aspect of the present disclosure, there is provided a gate driver comprising the current mirror circuit according to the first aspect defined above.

In some embodiments, the output node of the current driver circuit is coupled to a gate terminal of a power transistor.

The gate driver may be a high voltage gate driver.

The gate driver may be configured to implement a controlled shutdown.

According to a third aspect of the present disclosure, there is provided a method for generating an output current, the method comprising: providing a first reference current between the first and second current terminals of a first transistor; generating an output current between the first and second current terminals of a second transistor, the control terminal of the second transistor being coupled to the control terminal of the first transistor; and providing, at the first current terminal of the first transistor, a voltage corresponding to a voltage at the first current terminal of the second transistor.

In some embodiments, the step of providing, at the first current terminal of the first transistor, a voltage corresponding to a voltage at the first current terminal of the second transistor comprises: controlling a second reference current between the first and second current terminals of a third transistor, wherein the first current terminal of the third transistor is coupled to a control terminal of the third transistor, wherein the second current terminal of the third transistor is coupled to the first current terminal of the second transistor; controlling a third reference current between the first and second current terminals of a fourth transistor, wherein a control terminal of the fourth transistor is coupled to the control terminal of the third transistor; wherein the second current terminal of said fourth transistor is coupled to the first current terminal of said first transistor.

In some embodiments, the second reference current is equal to the third reference current.

In some embodiments, the first current terminal of the second transistor is coupled to a gate terminal of a power transistor, the method further comprising controlling the output current to steadily discharge a voltage at the gate terminal of the power transistor.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures.
Figure 1 schematically illustrates an example cascoded current mirror circuit;
Figure 2 schematically illustrates a non-cascoded current mirror circuit according to an example embodiment of the present disclosure;
Figure 3 schematically illustrates a non-cascoded current mirror circuit according to another example embodiment of the present disclosure;
Figure 4 schematically illustrates a voltage gate driver including the non-cascoded current mirror circuit of Figure 2, according to an example embodiment of the present disclosure; and
Figure 5 illustrates a method of controlling an output current according to an example embodiment of the present invention.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

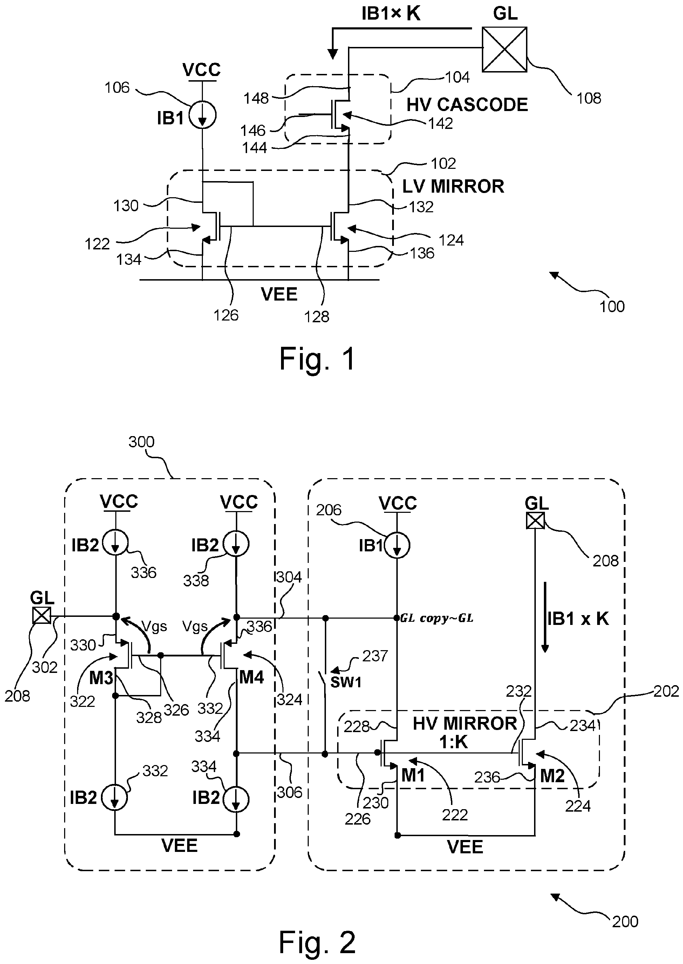

Figure 1 schematically illustrates an example cascoded current mirror circuit 100, comprising a low voltage (LV) current mirror 102 and a high voltage (HV) cascode 104.

The LV current mirror 102 comprises a first NMOS transistor 122 and a second NMOS transistor 124.

The gate 126 of the first NMOS transistor 122 and the gate 128 of the second NMOS transistor 124 are coupled to each other and to the drain 130 of the first NMOS transistor 122. The LV current mirror 102 is biased by a current source 106 coupled between the positive power supply potential VCC and the drain 130 of the first NMOS transistor 122. The drain 132 of the second NMOS transistor 124 is coupled to the HV cascode 104. The source 134 of the first transistor 122 and the source 136 of the second transistor 124 are coupled to the negative supply potential VEE. The current source 106 is configured to output a constant current IB1, such that the drain-source current of the first NMOS transistor 122 has a value IB1 when conducting in its "on" state. The current mirror ratio of the LV current mirror 102 is 1:K, such that the drain-source current of the second NMOS transistor 124 has a value IB1xK when conducting in its "on" state.

The HV cascode 104 comprises an HV cascode transistor 142, in the form of an NMOS transistor 142, of which the source 144 is coupled to the drain 132 of the second NMOS transistor 124 of the LV current mirror 102. The gate 146 of the HV cascode transistor 142 may be coupled to a control signal for switching a drain-source current of the HV cascode transistor 142. The drain 148 of the HV cascode transistor 142 is coupled to a node GL 108 that is to be charged or discharged by a constant current. For example, the node GL 108 may be coupled to a gate of an external device, such that the cascoded current mirror circuit 100 serves as a gate driver for the external device.

As an example, the node GL 108 may be required to discharge, by a constant current, from up to 25V down to -10V. The HV cascode/switches 104,142 allows the LV current mirror 102 to have an almost constant drain-source voltage VDS throughout this transition. For example, the HV cascode 104, 142 may keep the current stable around the correct value, e.g., 1.2A, during the transition. In a gate driver, this could be used to implement a controlled shutdown in the event of a fault condition.

However, the HV cascode 104, 142 needs to be very large to ensure the headroom of the LV current mirror 102 throughout the transition of the node GL 108 between its initial and final voltage when discharging. In some technologies, such as junction-isolated technology, there is no provision for an HV NMOS with enough voltage class and that can be used in a cascode configuration.

Figure 2 schematically illustrates a non-cascoded current mirror circuit 200, according to an example embodiment of the present disclosure. The non-cascoded current mirror circuit 200 comprises a high voltage (HV) current mirror 202, a first current source 206 configured to output a first reference current IB1, and matching circuitry 300.

The HV current mirror 202 comprises a first transistor M1 222 and a second transistor M2 224. In this embodiment, both the first and second transistors M1 222, M2 224 are NMOS transistors. The first (NMOS) transistor M1 222 comprises a control terminal 226 in the form of gate 226, a first current terminal 228 in the form of drain 228 and a second current terminal 230 in the form of source 230. The second (NMOS) transistor M2 224 also comprises a control terminal 232 in the form of gate 232, a first current terminal 234 in the form of drain 234 and a second current terminal 236 in the form of source 236. The drain 228 of the first transistor M1 22 is coupled to receive the first reference current IB1 from the first current source 206. The source 230 of the first (NMOS) transistor M1 222 and the source 236 of the second (NMOS) transistor M2 224 are coupled to a reference potential in the form of the negative supply potential VEE. The gate 226 of the first (NMOS) transistor M1 222 and the gate 232 of the second (NMOS) transistor M2 224 are coupled to each other. The drain 234 of the second (NMOS) transistor M2 224 is coupled to the output node GL 208 of the current mirror circuit 200.

The gate 226 of the first (NMOS) transistor M1 222 may be selectively coupled to the drain 228 of the first (NMOS) transistor M1 222 via a switch SW1 237. Closing the switch SW1 237 allows the current mirror circuit 200 to be reconfigured to operate as a simple current mirror. However, when operating the current mirror circuit 200 as a precise current mirror, the switch SW1 237 is open.

The HV current mirror 202 is biased by the first current source 206, which is coupled between the positive supply potential VCC and the drain 228 of the first (NMOS) transistor M1 222. The current source 206 is configured to output a current IB1, such that the drain-source current of the first (NMOS) transistor M1 222 has a value IB1 when conducting in its "on" state. The matching circuitry 300 comprises an input 302 coupled to the output node GL 208 of the current mirror circuit 200, and an output 304 coupled to the first drain 228 of the first (NMOS) transistor M1 222. The matching circuitry 300 is configured to provide, at the first drain 228 of the first transistor M1 222, a replica voltage GL_copy corresponding to voltage GL at the output node GL 208 of the current mirror circuit 200. Accordingly, the current through the second transistor M2 224 mirrors the current through the first transistor M1 222. The current mirror ratio of the HV current mirror 202 (determined by the relative specifications of the first and second transistors M1 222, M2, 224) is 1:K, such that the drain-source current of the second (NMOS) transistor M2 224 has a value IB1xK when conducting in its "on" state.

The matching circuitry 300 further comprises a third transistor M3 322, a fourth transistor M4 324, and second to fifth current sources 332, 334, 336, 338.

In this embodiment, both the third transistor M3 322 and fourth transistor M4 324 are PMOS transistors. The third transistor M3 322 comprises a control terminal 326 in the form of gate 326, a first current terminal 328 in the form of drain 328 and a second current terminal 330 in the form of source 330. The input 302 of the matching circuitry 300, coupled to the output node GL 208 of the current mirror circuit 200, is also coupled to the source 330 of the third transistor M3, 322. The gate 326 and drain 328 of the third transistor M3 322 are coupled together. The fourth transistor M4 324 comprises a control terminal 332 in the form of gate 332, a first current terminal 334 in the form of drain 334 and a second current terminal 336 in the form of source 336. The gate 332 of the fourth transistor M4 324 is coupled to the gate 326 of the third transistor M3 322. The source 336 of the fourth transistor M4 324 is coupled to the output 304 of the matching circuitry 300, which itself is coupled to the drain 228 of the first transistor M1 222.

The second current source 332 is coupled between the drain 328 of the third transistor M3 322 and the negative supply potential VEE and is configured to output a second reference current IB2. The third current source 334 is coupled between the drain 334 of the fourth transistor M4 324 and the negative supply potential VEE and is configured to provide a third reference current IB2. The fourth current source 336 is coupled between the positive supply potential VCC and the source 330 of the third transistor M3 322 and is configured to provide a fourth reference current IB2. The fifth current source 338 is coupled between the positive supply potential VCC and the source 336 of the fourth transistor M4 324 and is configured to provide a fifth reference current IB2. In this embodiment, each of the second, third, fourth and fifth reference currents provided by the second, third, fourth and fifth current sources 332, 334, 336, 338 respectively have the same value IB2.

With the switch SW1 237 in the "open" state, the matching circuitry 300 generates a copy, at its output 304, of the voltage at the output node GL 208. The voltage at the gate 326 of the third transistor M3 322 is shifted downwards relative to the voltage at the output node GL 208, by an amount Vgs being the gate-source voltage of the third transistor M3 322. Because the gate 326 and drain 328 of the third transistor M3 322 are coupled together, the value of the shift Vgs is effectively fixed by the drain-source current of the third transistor M3 322 which is controlled by the second current source 332 to a value IB2. The voltage at the source 336 of the fourth transistor M4 324 is shifted upwards relative to the voltage at the gate 332 of the fourth transistor M4 324 by the same amount Vgs being the gate-source voltage of the fourth transistor M4 324. The gate-source voltages Vgs of the third and fourth transistors M3 322 and M4 324 are the same in this example embodiment because the third and fourth transistors M3 322, M4 324 are matched devices, have the same gate voltage, and are biased with the same current IB2. Consequently, the voltage at the output 304 of the matching circuitry 300, and therefore at the drain 228 of the first (NMOS) transistor M1 222, is a 1:1 copy of the voltage at the node GL 208. Although a 1:1 ratio is preferable, a small mismatch between the values would produce only second order effects at the output current of the current mirror circuit.

In this embodiment, the presence of the third current source 336, providing a reference current IB2 equal to the reference current provided by the first current source 332, ensures that the third transistor M3 322 does not drain current from the output node GL 208. However, the third current source 336 may be omitted in other embodiments. Similarly, the presence of the fourth current source 338, providing a reference current IB2 equal to the reference current provided by the second current source 334, ensures that the fourth transistor M4 324 does not drain current from the first current source 206. However, the fourth current source 338 may be omitted in other embodiments, or may be effectively be combined with the first current source 206.

With switch SW1 237 open, the gate 226 of the first transistor M1 222 must adjust itself to allow the current IB1 to flow through the first transistor M1 222. The coupling from the gate 226 of the first transistor M1 222 to the drain 334 of the fourth transistor M4 324 provides a suitable pathway for charging/discharging the gate 226 as required. However, in other embodiments, a different pathway may be provided.

As a result, the HV mirror 202 of the current mirror circuit 200, comprising the first and second transistors M1 222 and M2 224, with the first transistor M1 222 biased by current IB1 and having its drain-source voltage Vds matched with the voltage at the output node GL 208, will precisely mirror a current IB1xK at the output node 208 of the current mirror circuit 200. The output current IB1xK is regulated by an open loop to avoid incurring a delay.

In some embodiments, the current mirror circuit 200 may be programmable or adjustable, for example to control the values of IB1, IB2 and/or K. In some applications, the values of IB1, IB2 and/or K may be held constant.

By mitigating VDS modulation effects, the current mirror circuit 200 enables implementation of a non-cascoded high voltage (HV) current mirror, with performance comparable to that of a conventional cascoded low voltage (LV) current mirror.

The current mirror circuit 200 provides real-time sensing and scaling of the voltage at the output node GL 208, by matching the drain-source voltage of the first transistor M1 222 to the drain-source voltage of the second transistor M2 224 (i.e., to the voltage at the output node GL 208 of the current mirror circuit 200). Accordingly, the current mirror circuit 200 is able to perform real-time VDS-modulation compensation.

The configuration of the non-cascoded current mirror circuit 200 of Figure 2 also ensures higher headroom than the cascoded current mirror circuit 100 of Figure 1. When discharging a voltage from a dominantly capacitative external gate-like node coupled to the output node GL 208 by a constant current, this results in the linear behaviour of the voltage transition being maintained over a wider range of voltages.

The absence of an HV cascode transistor allows implementation of the current mirror circuit 200 in cost-saving technologies that do not provide HV MOS that can be used in a cascode configuration, such as junction-isolated technology, due to the maximum drop between their source and the substrate voltage.

When the switch SW1 237 is closed, the non-cascoded current mirror 200 is effectively configured as a simple current mirror. By opening the switch SW1 237, the non-cascoded current mirror 200 is reconfigured into a precise current mirror due to the presence of the matching circuitry 300. Accordingly, the matching circuitry 300 enables the performance of any simple current mirror to be improved.

The non-cascoded current mirror circuit 200 does not require a cascode, and therefore results in a significant reduction in die area, while keeping the same performance as a cascoded structure.

Although the HV mirror 202 is configured in this example embodiment for high voltage applications, the skilled person will understand that the HV mirror 202 could be replaced by a LV mirror such as the LV mirror 102 of Figure 1 for applications in which the voltage at node GL 108 transitions between low voltages.

In the embodiment of the current mirror circuit 200 described above, the first and second transistors are NMOS transistors, the third and fourth transistors are PMOS transistors, and the control terminal, first current terminal and second current terminal of each transistor corresponds to its gate, drain and source terminals respectively. The skilled person will appreciate that in other embodiments of the current mirror circuit, the first and second transistors may be PMOS transistors and the third and fourth transistors may be NMOS transistors, while the control terminal, first current terminal and second current terminal of each transistor again correspond to the respective gate, drain and source terminals. Such embodiments, the reference potential defined in the claims would correspond to the high supply voltage rail. The skilled person would further appreciate that other embodiments exist in which (i) the first and second transistors are NPN transistors and the third and fourth transistors are PNP transistors, or (ii) the first and second transistors are PNP transistors and the third and fourth transistors are NPN transistors. In such embodiments, the control terminal, first current terminal and second current terminal of each transistor would correspond to the respective base, collector and emitter terminals.

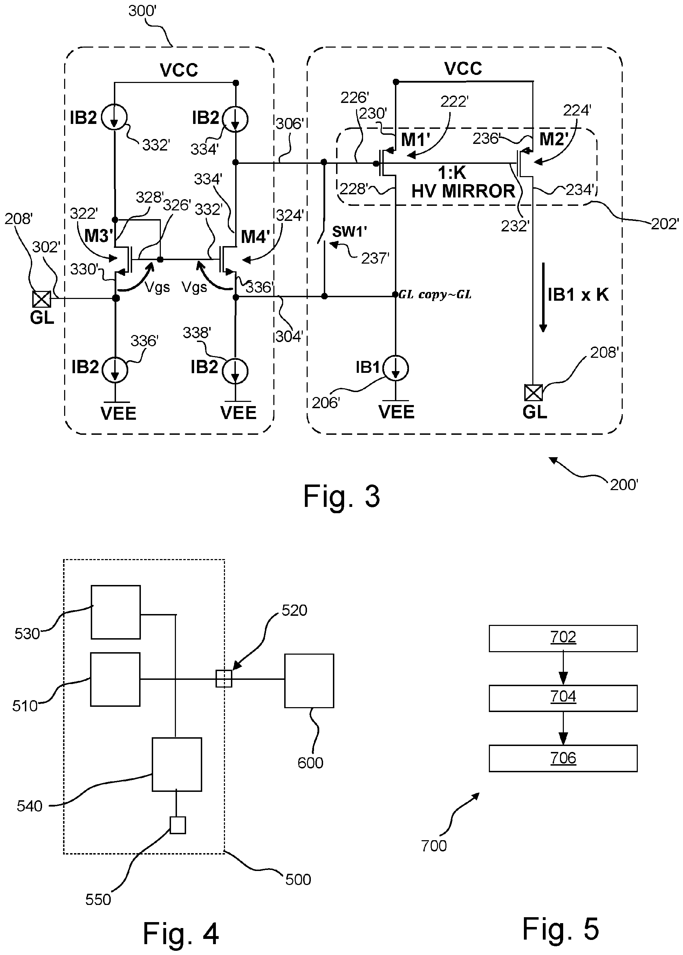

As an example, Figure 3 schematically illustrates another current mirror circuit 200' according to alternative example embodiment of the present disclosure. Features of current mirror circuit 200' corresponding to those of current mirror circuit 200 are labelled using similar reference numbers (appended by an apostrophe). The non-cascoded current mirror circuit 200' comprises a high voltage (HV) current mirror 202', a first current source 206' configured to output a first reference current IB1, and matching circuitry 300'.

The HV current mirror 202' comprises a first transistor M1' 222' and a second transistor M2' 224'. In this embodiment, both the first and second transistors M1' 222', M2' 224' are PMOS transistors. The first (PMOS) transistor M1' 222' comprises a control terminal 226' in the form of gate 226', a first current terminal 228' in the form of drain 228' and a second current terminal 230' in the form of source 230'. The second (PMOS) transistor M2' 224' also comprises a control terminal 232' in the form of gate 232', a first current terminal 234' in the form of drain 234' and a second current terminal 236' in the form of source 236'. The drain 228' of the first transistor M1' 222' is coupled to receive the first reference current IB1 from the first current source 206'. The source 230' of the first (PMOS) transistor M 1' 222' and the source 236' of the second (PMOS) transistor M2' 224' are coupled to a reference potential in the form of the positive supply potential VCC. The gate 226' of the first (PMOS) transistor M1' 222' and the gate 232' of the second (PMOS) transistor M2' 224' are coupled to each other. The drain 234' of the second (PMOS) transistor M2' 224' is coupled to the output node GL 208' of the current mirror circuit 200'. As in the previous embodiment, the gate 226' of the first (PMOS) transistor M1' 222 may be selectively coupled to the drain 228 of the first (PMOS) transistor M1' 222' via a switch SW1' 237.

The first current source 206' is coupled between the negative supply potential VEE and the drain 228' of the first (PMOS) transistor M1' 222' and provides a current IB1 through the first transistor M1' 222'. The matching circuitry 300', coupled between the output node GL 208' of the current mirror circuit 200', and the first drain 228' of the first (PMOS) transistor M1' 222', is configured to provide a replica voltage GL_copy at the first drain 228' of the first transistor M1' 222', corresponding to voltage GL at the output node GL 208' of the current mirror circuit 200'. Accordingly, the current through the second transistor M2' 224' is IB1xK, mirroring the current through the first transistor M1' 222', with a current mirror ratio 1:K.

The matching circuitry 300' further comprises a third transistor M3' 322', a fourth transistor M4' 324', and second to fifth current sources 332', 334', 336', 338'.

In this embodiment, both the third transistor M3' 322' and fourth transistor M4' 324' are NMOS transistors. The third (NMOS) transistor M3' 322' comprises a control terminal 326' in the form of gate 326', a first current terminal 328' in the form of drain 328' and a second current terminal 330' in the form of source 330'. The input 302' of the matching circuitry 300', coupled to the output node GL 208' of the current mirror circuit 200', is also coupled to the source 330' of the third transistor M3' 322'. The gate 326' and drain 328' of the third (NMOS) transistor M3' 322' are coupled together. The fourth (NMOS) transistor M4' 324' comprises a control terminal 332' in the form of gate 332', a first current terminal 334' in the form of drain 334' and a second current terminal 336' in the form of source 336'. The gate 332' of the fourth (NMOS) transistor M4' 324' is coupled to the gate 326' of the third (NMOS) transistor M3' 322'. The source 336' of the fourth transistor M4' 324' is coupled to the output 304' of the matching circuitry 300', which itself is coupled to the drain 228' of the first transistor M1' 222'.

The second current source 332' is coupled between the drain 328' of the third transistor M3' 322' and the positive supply potential VCC and is configured to output a second reference current IB2. The third current source 334' is coupled between the drain 334' of the fourth transistor M4' 324' and the positive supply potential VCC and is configured to provide a third reference current IB2. The fourth current source 336' is coupled between the negative supply potential VEE and the source 330' of the third transistor M3' 322' and is configured to provide a fourth reference current IB2. The fifth current source 338' is coupled between the negative supply potential VEE and the source 336' of the fourth transistor M4' 324' and is configured to provide a fifth reference current IB2. As in the previous embodiment, each of the second, third, fourth and fifth reference currents provided by the second, third, fourth and fifth current sources 332', 334', 336', 338' respectively may have the same value IB2.

Operation of the current mirror circuit 200' of Figure 3 will be apparent to the skilled person based on the description of the current mirror circuit 200 of Figure 2.

Figure 4 schematically illustrates an application of the non-cascoded current mirror circuit 200 described above, in the form of a (high) voltage gate driver 500 according to an example embodiment of the present disclosure. In this example embodiment, the gate driver 500 is used to drive the gate of a power transistor 600. The power transistor 600 may be any suitable power switch which needs to be driven by a voltage gate driver 500 such as, by way of non-exhaustive examples, an IGBT (Insulated Gate Bipolar Transistor) or a power MOSFET (Metal-Oxide-Semiconductor Field-Effect Transistor). The gate driver 500 comprises a current source 510 in the form of the non-cascoded current mirror circuit 200, which is used as a selectable current generator. The output node GL 208 of the current mirror circuit 200 may be connected, via an output node 520 of the gate driver 500, to the gate of the power transistor 600. The gate driver 500 includes other blocks, such as an operational amplifier circuit 530, for controlling the voltage at the output node 520 during a regulating mode, and a pull switch circuit 540, for pulling the voltage at the output node 520 to a reference voltage 550 during a pull mode. Each of the current mirror circuit 510, operational amplifier circuit 530 and pull switch circuit 540 is coupled to the same output node 520. In particular, the non-cascoded current mirror circuit 200, 510 may provide a soft shutdown mode, which provides for safe turn-off of a power transistor in the event of a fault condition. For example, during a soft shutdown, the voltage at the output node 520 of the gate driver 500 may be pulled to a reference voltage in a controlled manner, by steadily reducing the gate voltage at the output node 520 of the voltage gate driver 500. This may avoid the occurrence of high voltage spikes that might otherwise be caused by abruptly cutting off the gate voltage. Soft shutdown modes may also be beneficial in other fault conditions. By using the current mirror circuit 200 for the soft shutdown mode may reduce the die area occupied by the soft-shut-down feature. The current mirror circuit 200 may be used to steadily reduce the voltage at the output node 520 of the gate driver 500 to a reference voltage in the form of the low voltage supply rail VEE by means of a constant current. This may be achieved by holding the reference current IB1 at a constant value.

Figure 5 illustrates a method 700 according to an example embodiment of the present disclosure. The method 700 comprises a step 702 of providing a first reference current IB1 between the first and second current terminals 228, 230 of a first transistor M1 222. The method 700 further comprises a step 704 of generating an output current between the first and second current terminals 234, 236 of a second transistor M2 224, the control terminal 232 of the second transistor M2 224 being coupled to the control terminal 226 of the first transistor M1 222. The method 700 further comprises a step 706 of providing, at the first current terminal 228 of the first transistor M1 222, a voltage GL_copy corresponding to a voltage GL at the first current terminal 234 of the second transistor M2 224.

The step 706 of providing, at the first current terminal 228 of the first transistor M1 222, a voltage GL_copy corresponding to a voltage GL at the first current terminal 234 of the second transistor M2 224 may comprise driving a second reference current IB2 between the first and second current terminals 328, 330 of a third transistor M3 322, wherein the first current terminal 328 of the third transistor M3 322 is coupled to a control terminal 326 of the third transistor M3 322, wherein the second current terminal 330 of the third transistor M3 322 is coupled to the first current terminal 234 of the second transistor M2 224. The step 706 may further comprise driving a third reference current IB2 between the first and second current terminals 334, 336 of a fourth transistor M4 324, wherein a control terminal 332 of the fourth transistor M4 324 is coupled to the control terminal 326 of the third transistor M3 322. The second current terminal 336 of the fourth transistor M4 324 may be coupled to the first current terminal 228 of the first transistor M1 222.

In the method 700, the second reference current IB2 may be equal to the third reference current IB2.

Whilst the above examples have been described for the use in gate drivers, the current mirror described herein can be used in any suitable system or application.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale.

It will be appreciated that any components said to be coupled may be coupled or connected either directly or indirectly. In the case of indirect coupling, additional components may be located between the two components that are said to be coupled.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A current mirror circuit comprising:
a first current source for providing a first reference current;
a first transistor having a control terminal, a first current terminal coupled to receive the first reference current, and a second current terminal coupled to a reference potential;
a second transistor having a control terminal coupled to the control terminal of the first transistor, a first current terminal coupled to an output node of the current mirror circuit, and a second current terminal coupled to the reference potential; and
matching circuitry having an input coupled to the output node of the current mirror circuit, and an output coupled to the first current terminal of the first transistor, the matching circuitry being configured to provide, at the first current terminal of the first transistor, a replica voltage corresponding to a voltage at the output node of the current mirror circuit.

2. The current mirror circuit of claim 1, wherein each of said first transistor and said second transistor is a high voltage transistor.

3. The current mirror circuit of claim 1 or claim 2, wherein the replica voltage is a 1:1 copy of the voltage at the output node of the current mirror circuit.

4. The current mirror circuit of any one of the preceding claims, wherein the control terminal of the first transistor is coupled to the first current terminal of the first transistor via a switch.

5. The current mirror circuit of any one of the preceding claims, wherein the first current terminal of the second transistor is directly connected to the output node of the current mirror circuit.

6. The current mirror circuit of any one of the preceding claims, wherein the matching circuitry comprises:
a third transistor having a control terminal, a first current terminal coupled to the control terminal of the third transistor, and a second current terminal;
a fourth transistor having a control terminal coupled to the control terminal of the third transistor, a first current terminal, and a second current terminal;
a second current source configured to control a second reference current between the first and second current terminals of the third transistor; and
a third current source configured to control a third reference current between the first and second current terminals of the fourth transistor.
wherein said input of said matching circuitry is coupled to the second current terminal of the third transistor;
wherein said output of said matching circuitry is coupled to the second current terminal of the fourth transistor.

7. The current mirror circuit of claim 6, wherein the matching circuitry further comprises:
a fourth current source, configured to provide a fourth reference current to the second current terminal of the third transistor, wherein the fourth reference current is equal to the second reference current; and
a fifth current source, configured to provide a fifth reference current to the second current terminal of the fourth transistor, wherein the fifth reference current is equal to the third reference current.

8. The current mirror circuit of claim 6 or claim 7, wherein the first reference current is equal to the second reference current.

9. The current mirror circuit of any one of claims 6 to 8, wherein the first current terminal of the fourth transistor is coupled to the control terminal of the first transistor.

10. The current mirror circuit of any one of the preceding claims, further comprising one of the following features:
(i) wherein the first transistor and the second transistor are NMOS transistors, and the third transistor and the fourth transistor are PMOS transistors;
(ii) wherein the first transistor and the second transistor are PMOS transistors, and the third transistor and the fourth transistor are NMOS transistors;
(iii) wherein the first transistor and the second transistor are NPN transistors, and the third transistor and the fourth transistor are PNP transistors;
(iv) wherein the first transistor and the second transistor are PNP transistors, and the third transistor and the fourth transistor are NPN transistors.

11. A gate driver comprising the current mirror circuit of any one of the preceding claims.

12. The gate driver circuit of claim 11, wherein the output node of the current driver circuit is coupled to a gate terminal of a power transistor.

13. A method for controlling an output current, the method comprising:
providing a first reference current between the first and second current terminals of a first transistor;
generating an output current between the first and second current terminals of a second transistor, the control terminal of the second transistor being coupled to the control terminal of the first transistor; and
providing, at the first current terminal of the first transistor, a voltage corresponding to a voltage at the first current terminal of the second transistor.

14. The method of claim 13, wherein the step of providing, at the first current terminal of the first transistor, a voltage corresponding to a voltage at the first current terminal of the second transistor comprises:
driving a second reference current between the first and second current terminals of a third transistor, wherein the first current terminal of the third transistor is coupled to a control terminal of the third transistor, wherein the second current terminal of the third transistor is coupled to the first current terminal of the second transistor;
driving a third reference current between the first and second current terminals of a fourth transistor, wherein a control terminal of the fourth transistor is coupled to the control terminal of the third transistor;
wherein the second current terminal of said fourth transistor is coupled to the first current terminal of said first transistor.

15. The method of claim 14, wherein the second reference current is equal to the third reference current.
